(19) **Europäisches Patentamt**
**European Patent Office**
**Office européen des brevets**

(11) **EP 4 217 939 B1**

(12) **FASCICULE DE BREVET EUROPEEN**

(45) Date de publication et mention de la délivrance du brevet:
**08.01.2025 Bulletin 2025/02**

(21) Numéro de dépôt: **21798065.5**

(22) Date de dépôt: **24.09.2021**

(51) Classification Internationale des Brevets (IPC):
**G06N 10/40** *(2022.01)* **G06N 10/70** *(2022.01)*
**H03K 19/195** *(2006.01)*

(52) Classification Coopérative des Brevets (CPC):
**G06N 10/40; G06N 10/70; H03K 19/195**

(86) Numéro de dépôt international:
**PCT/FR2021/051645**

(87) Numéro de publication internationale:
**WO 2022/064155 (31.03.2022 Gazette 2022/13)**

(54) **SYSTEME DE STABILISATION AUTONOME D'ETATS QUANTIQUES AYANT UNE PARITE PREDETERMINEE POUR LA CORRECTION D'ERREUR**

SYSTEM ZUR AUTONOMEN STABILISIERUNG VON QUANTENZUSTÄNDEN MIT EINER VORBESTIMMTEN PARITÄT ZUR FEHLERKORREKTUR

SYSTEM FOR AUTONOMOUS STABILISATION OF QUANTUM STATES HAVING A PREDETERMINED PARITY FOR ERROR CORRECTION

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **25.09.2020 FR 2009795**

(43) Date de publication de la demande:
**02.08.2023 Bulletin 2023/31**

(73) Titulaires:
• **CENTRE NATIONAL DE LA RECHERCHE SCIENTIFIQUE (CNRS)**
**75016 Paris (FR)**
• **Ecole Normale Supérieure de Lyon**
**69007 Lyon (FR)**
• **Université Claude Bernard Lyon 1**
**69100 Villeurbanne (FR)**

(72) Inventeurs:
• **PERONNIN, Théau**
**75012 PARIS (FR)**

• **HUARD, Benjamin**
**69008 LYON (FR)**
• **JEZOUIN, Sébastien**
**75009 PARIS (FR)**
• **MARQUET, Antoine**
**69007 LYON (FR)**

(74) Mandataire: **Cabinet Netter**
**36, avenue Hoche**
**75008 Paris (FR)**

(56) Documents cités:
• **GERTLER JEFFREY M ET AL: "Protecting a bosonic qubit with autonomous quantum error correction", NATURE (LONDON), 20 April 2020 (2020-04-20), England, pages 243 - 248, XP055813171, Retrieved from the Internet <URL:https://arxiv.org/pdf/2004.09322v1.pdf> [retrieved on 20210611], DOI: 10.1038/ s41586-021-03257-0**

EP 4 217 939 B1

## Description

### DOMAINE DE L'INVENTION

L'invention concerne la stabilisation autonome d'états quantiques présentant une parité prédéterminée et la correction d'erreurs dans le codage d'information quantique, en particulier dans le codage qui encode de l'information dans un système bosonique ayant une dimension, au sens de l'espace de Hilbert, plus grande que les deux états nécessaires pour encoder un bit d'information.

### ETAT DE LA TECHNIQUE

La mise en oeuvre d'un traitement d'information quantique nécessite de mettre en place des protocoles de correction d'erreur permettant de corriger les changements indésirables de l'état des qubits qui se produisent inévitablement en raison de leur couplage au monde extérieur.

Dans les protocoles d'information quantique de type bosonique, l'information est encodée dans des états d'un oscillateur harmonique quantique.

Dans l'ensemble de ce texte, on entend par oscillateur harmonique tout oscillateur dont la fréquence caractéristique ne change pas plus de 20% par quantum d'excitation.

Les états de l'oscillateur peuvent être décomposés sur la base des états de Fock, chaque état de Fock correspondant à un nombre particulier de bosons compris dans l'oscillateur.

La parité du nombre de bosons peut permettre de définir une parité pour les états de l'oscillateur harmonique quantique. Un état pair de l'oscillateur peut être défini lorsque dans la décomposition de cet état sur la base des états de Fock, les seuls coefficients non nuls sont les coefficients des états de Fock correspondant à un nombre pair de bosons.

Des procédés de correction d'erreur quantique sont connus pour corriger certaines erreurs, notamment dans le cas de protocole où le codage d'information utilise uniquement des états de l'oscillateur harmonique quantique de parité particulière.

Ces procédés de correction d'erreur sont fondés sur un maintien de la parité des états qui codent l'information, voir par exemple les documents OFEK Nissim et al. « Extending the lifetime of a quantum bit with error correction in superconducting circuits », Nature 536 pages 441 à 445; MICHAEL Marios H.et al. « New Class of Quantum Error-Correcting Codes for a Bosonic Mode », Physical Review X Vol.6 pages 031006; GERTLER Jeffrey M. et al. « Protecting a Bosonic Qubit with Autonomous Quantum Error Correction » <https://arxiv.org/abs/2004.09322>. Par exemple si une erreur se produit et que la parité est changée, l'erreur peut être corrigée en ajoutant un boson dans l'oscillateur harmonique quantique.

Ces procédés de correction d'erreur peuvent cependant être extrêmement difficiles à réaliser expérimentalement. C'est le cas quand ils nécessitent de mesurer continuellement la parité afin de détecter en temps réel les changements de parité lorsqu'ils se produisent et appliquer immédiatement les corrections, comme par exemple dans les documents précédemment cités de OFEK Nissim et GERTLER Jeffrey M.

Des procédés de correction autonome, plus simples à mettre en oeuvre, sont connus, voir par exemple le document précédemment cité de GERTLER Jeffrey M. Ces procédés reposent sur une ingénierie du système permettant que la détection et la correction des erreurs soient réalisées de façon autonome, sans intervention de l'expérimentateur, à l'intérieur même du système quantique.

Les procédés de correction autonome de l'art antérieur ne donnent cependant pas entière satisfaction car dans les cas où aucune erreur ne s'est produite, une correction peut tout de même être apportée et un boson peut être ajouté dans l'oscillateur harmonique. Ce boson ajouté induit un changement de la parité alors qu'elle avait la valeur prédéterminée, ce qui provoque une erreur.

Il existe donc un besoin d'un protocole de correction d'erreur plus sélectif sur la parité, c'est-à-dire un protocole de correction d'erreur qui n'apporte une correction que lorsque la parité n'a pas une valeur prédéterminée.

### EXPOSE DE L'INVENTION

Un but de l'invention est de proposer un protocole de correction d'erreur plus sélectif sur la parité que dans l'art antérieur.

Le but est atteint dans le cadre de la présente invention grâce à un système de stabilisation autonome d'états quantiques comprenant :

- un oscillateur harmonique quantique configuré pour porter une information encodée dans des états de l'oscillateur ayant une parité prédéterminée d'un nombre de bosons compris dans l'oscillateur harmonique,
- un dispositif auxiliaire configuré pour être dans un état fondamental |g> ou dans un état excité |f> parmi une pluralité d'états excités, le dispositif étant couplé à l'oscillateur de manière dispersive, de sorte qu'une différence de fréquence entre l'état fondamental |g> et l'état excité |f> dépend de manière linéaire d'un décalage de fréquence $\chi$ et du nombre de bosons,

- un dissipateur configuré pour passer d'un état excité |1> dans un état fondamental |0>,
- un excitateur configuré pour générer des premier et deuxième peignes de fréquences, destinés à être envoyés vers au moins l'un parmi l'oscillateur harmonique quantique, le dispositif auxiliaire et le dissipateur de sorte à ajouter un boson dans l'oscillateur harmonique si le nombre de bosons n'a pas la parité prédéterminée,
- un premier écart fréquentiel séparant deux raies successives du premier peigne de fréquences étant égal au double du décalage de fréquence $\chi$ et étant égal au double d'un deuxième écart fréquentiel séparant deux raies successives du deuxième peigne, dans lequel les premier et deuxième peignes présentent des pics dans le domaine temporel, les pics du premier peigne étant décalés temporellement par rapport aux pics du deuxième peigne.

Un tel système est avantageusement complété par les différentes caractéristiques suivantes prises seules ou en combinaison :

- le système est configuré pour être, pour chaque entier k d'un ensemble d'entiers, dans :

  - un premier niveau défini par un premier nombre de bosons égal à l'entier k, l'état fondamental |g> et l'état fondamental |0>,
  - un deuxième niveau défini par un deuxième nombre de bosons égal à l'entier k+1, l'état fondamental |g> et l'état fondamental |0>,
  - un troisième niveau dans lequel le dispositif auxiliaire est dans l'état excité |f> et le dissipateur est dans l'état stable |0>,
  - un quatrième niveau dans lequel le dispositif auxiliaire est dans l'état fondamental |g> et le dissipateur est dans l'état excité |1>,
  - l'excitateur étant configuré pour coupler, pour chaque entier k, les premiers, troisième et quatrième niveaux si l'entier k n'a pas la parité prédéterminée, de sorte à déplacer le système du premier niveau dans le deuxième niveau,
  - l'excitateur étant configuré pour générer les premier et deuxième peignes de fréquences de sorte que, pour chaque entier k :

    - le premier peigne comprend une première raie si l'entier k n'a pas la parité prédéterminée, la première raie ayant une fréquence égale à une fréquence de transition entre les premiers et troisième niveaux, et
    - le deuxième peigne comprend une deuxième raie ayant une fréquence égale à une fréquence de transition entre les troisième et quatrième niveaux ;
    - l'oscillateur harmonique comprend le deuxième nombre de bosons égal à l'entier k+1 dans le quatrième niveau ;
    - l'oscillateur harmonique quantique est un premier résonateur micro-onde supraconducteur, le système auxiliaire est un transmon, le dissipateur est un deuxième résonateur micro-onde supraconducteur ayant un facteur de qualité inférieur à un facteur de qualité du premier résonateur micro-onde supraconducteur ;
    - une amplitude des raies du premier peigne de fréquences et du deuxième peigne de fréquences est caractérisée par une fréquence de couplage, la fréquence de couplage étant inférieure au quart du deuxième écart fréquentiel ;
    - l'information est encodée dans des états de l'oscillateur correspondant à un nombre de bosons compris entre un entier plancher $k_{min}$ ayant la parité prédéterminée et un entier plafond $k_{max}$ ayant la parité prédéterminée, l'ensemble d'entiers étant égal aux entiers compris entre les entiers $k_{min}$ - 1 et $k_{max}$ - 1.

L'invention porte également sur un procédé de stabilisation autonome d'états quantiques comprenant les étapes suivantes :

- encoder une information dans des états d'un oscillateur harmonique quantique, les états ayant une parité prédéterminée d'un nombre de bosons compris dans l'oscillateur harmonique,
- coupler de manière dispersive l'oscillateur harmonique à un dispositif auxiliaire, de sorte qu'une différence de fréquence entre un état fondamental |g> du dispositif auxiliaire et un état excité |f> du dispositif auxiliaire dépend de manière linéaire d'un décalage de fréquence $\chi$ et du nombre de bosons,
- coupler le dispositif auxiliaire à un dissipateur configuré pour passer d'un état excité |1> dans un état fondamental |0> ;
- générer des premier et deuxième peignes de fréquences, un premier écart fréquentiel séparant deux raies successives du premier peigne de fréquences étant égal au double du décalage de fréquence $\chi$ et égal au double d'un deuxième écart fréquentiel séparant deux raies successives du deuxième peigne et

- envoyer les premier et deuxième peignes de fréquences vers au moins l'un parmi l'oscillateur harmonique quantique, le dispositif auxiliaire et le dissipateur de sorte à ajouter un boson dans l'oscillateur harmonique si le nombre de bosons n'a pas la parité prédéterminée, dans lequel les premier et deuxième peignes présentent des pics dans le domaine temporel, les pics du premier peigne étant décalés temporellement par rapport aux pics du deuxième peigne.

Un tel procédé est avantageusement complété par les différentes caractéristiques ou étapes suivantes prises seules ou en combinaison :

- une optimisation de l'amplitude des raies des premier et deuxième peignes de fréquences, l'amplitude des raies étant caractérisée par une fréquence de couplage, comprenant les étapes suivantes :

  - (E1) choisir une valeur de fréquence de couplage inférieure au quart du deuxième écart fréquentiel,
  - (E2) mesurer un temps de vie des états ayant un nombre de bosons de la parité prédéterminée et
  - (E3) modifier la valeur de la fréquence de couplage en fonction du temps de vie mesuré selon un algorithme d'optimisation du temps de vie de sorte à identifier une valeur optimale de la fréquence de couplage correspondant à un maximum du temps de vie ;
  - une optimisation d'un taux de désexcitation $\gamma_{dis}$ égal à la probabilité de passer du niveau $|1\rangle$ vers le niveau $|0\rangle$ par unité de temps, comprenant les étapes suivantes :

    - (S1) choisir une valeur du taux de désexcitation inférieure au deuxième écart fréquentiel,
    - (S2) mesurer un temps de vie des états ayant un nombre de bosons de la parité prédéterminée et
    - (S3) modifier la valeur du taux de désexcitation en fonction du temps de vie mesuré selon un algorithme d'optimisation du temps de vie de sorte à identifier une valeur optimale du taux de désexcitation correspondant à un maximum du temps de vie.

## DESCRIPTION DES FIGURES

D'autres caractéristiques et avantages de l'invention ressortiront encore de la description qui suit, laquelle est purement illustrative et non limitative, et doit être lue en regard des dessins annexés sur lesquels :

La figure 1 est une représentation schématique des états d'un oscillateur harmonique.
La figure 2 est une représentation schématique d'un système de stabilisation d'états quantiques.
La figure 3 est une représentation schématique d'une architecture de niveaux d'énergie d'un système de stabilisation d'états quantiques.
La figure 4 est une représentation schématique de fonctions caractérisant l'évolution temporelle de peignes de fréquences générés par le système de stabilisation d'états quantiques.

## DESCRIPTION DETAILLEE DE L'INVENTION

La présente invention a pour but de stabiliser une parité prédéterminée du nombre de bosons d'un oscillateur harmonique quantique de manière autonome. Par souci de simplicité, il est supposé dans la suite que c'est la parité paire qu'il faut stabiliser. Un nombre impair de bosons correspond donc à une erreur qu'il convient de corriger. Des changements triviaux permettraient de stabiliser la parité impaire.

### *Canaux d'erreur et de correction*

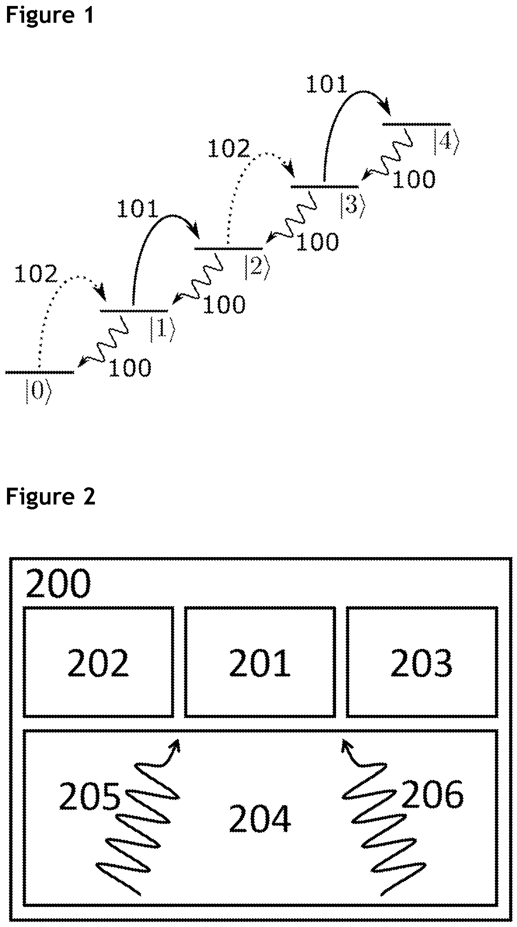

Le principal canal d'erreur conduisant à un changement de parité est la perte d'un boson de l'oscillateur harmonique quantique. La figure 1 représente schématiquement les états d'un oscillateur harmonique et le canal d'erreur. Un oscillateur harmonique peut être dans un état |k>, où k est un entier et représente le nombre de bosons k contenus dans l'oscillateur. Les états |0>, |1>, etc., de l'oscillateur harmonique quantique sont représentés par des traits horizontaux sur la figure 1. Deux états successifs de l'oscillateur sont séparés d'une différence d'énergie constante $\hbar\omega_{osc}$ où $\omega_{osc}$ est la fréquence de résonance de l'oscillateur harmonique quantique, l'état |0> étant l'état de plus basse énergie. Le niveau d'énergie d'un état est représenté verticalement, de sorte que les traits horizontaux des états |0>, |1>, etc., sont séparés verticalement de la même distance sur la figure 1. Le processus de relaxation 100 est une transition d'un état |k> vers un état |k-1> et correspond à la perte d'un boson.

Le processus de relaxation 100 est caractérisé par un taux de relaxation $\gamma_{osc}$, de sorte que la probabilité de transition d'un état |k> vers un état |k-1> par unité de temps est égale à $k \times \gamma_{osc}$.

Une manière de stabiliser la parité contre la perte d'un boson de manière autonome consiste à réaliser un canal de dissipation effectif 101 ajoutant un boson dans l'oscillateur harmonique quantique si le nombre de bosons est impair. Dans la figure 1, ce canal est représenté par des flèches continues entre un état |k> vers un état |k+1> lorsque k est impair. Dans le cas de la figure 1 et en accord avec le choix de stabiliser la parité paire, il est choisi de stabiliser des nombres k de bosons pairs, |0>, |2>, |4>, etc.

Le canal de dissipation effectif 101 ou processus de correction 101 est caractérisé par un taux de correction $\gamma_{up}$ qui est égal à la probabilité d'ajout d'un boson par unité de temps. Selon la manière dont le processus de correction 101 est réalisé, le taux de correction $\gamma_{up}$ peut dépendre du nombre de bosons k.

Le processus de stabilisation de la parité est d'autant plus efficace que le taux de correction $\gamma_{up}$, est grand devant le taux de relaxation $\gamma_{osc}$.

Cependant, dans l'art antérieur, les réalisations d'un canal de dissipation effectif 101 induisent un canal d'altération 102, comme par exemple dans le document précédemment cité GERTLER Jeffrey M. Le canal d'altération 102 a comme effet d'ajouter un boson dans l'oscillateur alors que la parité est paire ce qui est indésirable. Une parité paire du nombre de bosons correspond en effet à un état de l'oscillateur qu'il convient de ne pas modifier.

Dans la figure 1, le canal d'altération 102 est représenté par des flèches en pointillés depuis un état |k> vers un état |k+1> lorsque k est pair.

Le canal d'altération 102 ou processus d'altération 102 est caractérisé par un taux d'altération $\overline{\gamma}_{up}$, qui est égal à la probabilité d'ajout d'un boson par unité de temps. Selon la manière dont le processus de correction 101 est réalisé, le taux d'altération $\overline{\gamma}_{up}$ peut dépendre du nombre de bosons k.

Il est important de minimiser le taux d'altération $\overline{\gamma}_{up}$ pour au moins les trois raisons suivantes.

Le canal d'altération 102 engendre des erreurs de parité.

Dans les réalisations d'un canal de dissipation effectif 101 de l'art antérieur, le taux d'altération $\overline{\gamma}_{up}$ croît lorsque le taux de correction $\gamma_{up}$ croît. Cela limite la capacité à corriger le processus de relaxation 100, car augmenter le taux de correction $\gamma_{up}$ augmente également le taux d'altération $\overline{\gamma}_{up}$.

Dans certains cas comme dans le code de chat à quatre pattes voir MIRRAHIMI NJP et al. "Dynamically protected cat-qubits: a new paradigm for universal quantum computation", New Journal of Physics, vol. 16 et ci-après, les erreurs de parité engendrées par le processus d'altération 102 ne sont pas corrigées par le processus de correction 101 mais au contraire aggravées.

*Code de chats à quatre pattes*

Un chat à quatre pattes est défini comme la superposition de quatre états cohérents de l'oscillateur harmonique quantique dont les phases diffèrent d'une valeur de $\pi/2$. Lorsqu'un chat à quatre pattes est décomposé sur les états |k>, les seuls coefficients non nuls correspondent à des nombres p de bosons congrus à n modulo 4, où n est un entier prédéterminé qui peut valoir 0, 1, 2 ou 3. Chaque valeur de l'entier prédéterminé n définit un chat à quatre pattes. Il existe donc quatre chats à quatre pattes.

Les chats à quatre pattes correspondant à l'entier prédéterminé n égal à 0 ou à 2 peuvent permettre de définir un premier qubit logique.

Les chats à quatre pattes correspondant à l'entier prédéterminé n égal à 1 ou à 3 définissent un second qubit logique. Un changement de parité (causé par exemple par une perte ou un gain d'un boson dans l'oscillateur harmonique) dans un qubit logique est équivalent à un changement du qubit logique. Autrement dit la perte ou le gain d'un boson dans l'oscillateur harmonique fait passer du premier qubit logique au second qubit logique et inversement.

Un code de chat à quatre pattes consiste à corriger une telle erreur. La perte d'un boson peut être corrigée en ajoutant immédiatement un boson dans l'oscillateur harmonique. Le gain d'un boson peut être corrigé en retirant immédiatement un boson de l'oscillateur harmonique.

La perte ou l'ajout consécutif de deux bosons de l'oscillateur harmonique ne peut pas, en revanche, être corrigé et provoque une erreur logique.

Pour qu'une perte successive de deux bosons se produise, il est nécessaire de perdre un premier boson par le processus de relaxation 100, puis de perdre un deuxième boson par le processus de relaxation 100 avant que le gain d'un boson par processus de correction 101 ne se produise.

La probabilité que le deuxième boson soit perdu avant que le processus de correction agisse vaut le rapport $\dfrac{\gamma_{osc}}{\gamma_{up}}$ du taux de relaxation $\gamma_{osc}$ sur le taux de correction $\gamma_{up}$, dans la limite où $\gamma_{up}$ est grand devant $\gamma_{osc}$. C'est dans cette limite que le procédé de stabilisation de la parité prédéterminée est efficace.

Pour qu'un gain successif de deux bosons se produise, il est nécessaire de gagner un premier boson par le processus d'altération 102, puis par exemple de gagner un deuxième boson par le processus de correction 101 avant que la perte d'un boson par le processus de relaxation 100 ne se produise.

La probabilité que le deuxième boson soit gagné avant que le processus de relaxation agisse vaut $1 - \frac{\gamma_{osc}}{\gamma_{up}}$, dans la limite où $\gamma_{up}$ est grand devant $\gamma_{osc}$.

Le processus de correction 101 ne corrige pas une erreur causée par le processus d'altération 102, mais conduit au contraire avec une forte probabilité à l'ajout d'un deuxième boson, ce qui engendre une erreur logique.

## *Sélectivité*

La présente invention permet d'augmenter significativement le rapport $\gamma_{up}/\overline{\gamma}_{up}$ du taux d'altération sur le taux de correction. Ce rapport peut être nommé sélectivité du protocole de correction d'erreur.

La sélectivité donne le rapport de la probabilité d'ajouter un boson lorsque c'est souhaitable c'est-à-dire lorsque le nombre de bosons est impair sur la probabilité d'ajouter un boson lorsque ce n'est pas souhaitable c'est-à-dire lorsque le nombre de bosons est pair.

Plus la sélectivité est importante et plus le protocole corrige les erreurs dues au canal de relaxation 100 en ajoutant un boson lorsque le nombre de bosons est impair, sans ajouter un boson alors que le nombre de bosons est pair.

## *Système de stabilisation d'états quantiques*

Un système 200 de stabilisation d'états quantiques configuré pour mettre en oeuvre un protocole de correction d'erreur quantique est représenté schématiquement en figure 2.

Le système 200 comprend un oscillateur harmonique quantique 202, un dispositif auxiliaire non-linéaire 201 qui est couplé de manière dispersive à l'oscillateur harmonique quantique 202.

L'oscillateur harmonique quantique a une fréquence de résonance $\omega_{osc}$. Son hamiltonien peut être représenté comme suit : $H_{osc} = \hbar\omega_{osc}a{+}a$ Où $\hbar$ est la constante de Planck réduite et $a$ et $a^+$ sont les opérateurs de création et d'annihilation de l'oscillateur harmonique quantique vérifiant $[a,a^+] = 1$. L'oscillateur harmonique sert à encoder de l'information quantique.

Le dispositif auxiliaire 201 peut être dans un niveau stable $|g\rangle$, et au moins un niveau excité $|f\rangle$. La fréquence de transition entre les états $|g\rangle$ et $|f\rangle$ lorsque l'oscillateur harmonique quantique est dans son état fondamental est notée $\omega_{gf}$. La différence d'énergie ou, de manière équivalente, la différence de fréquence $\omega_{gf}(k)$ entre l'état ou le niveau fondamental $|g\rangle$ et l'état ou le niveau excité $|f\rangle$ dépend de manière linéaire du nombre k de bosons dans l'oscillateur harmonique quantique (voir BLAIS Alexandre et al. "Cavity quantum electrodynamics for superconducting electrical circuits: An architecture for quantum computation", Physical Review A vol. 69, page 062320). Une telle différence d'énergie $\omega_{gf}(k)$ peut être caractérisée par un décalage de fréquence $\chi$ sous la forme $\omega_{gf}(k) = \omega_{gf} + k \times \chi$. La différence de fréquence $\omega_{gf}(k)$ entre l'état fondamental $|g{>}$ et l'état excité $|f{>}$ dépend de manière linéaire du décalage de fréquence $\chi$ et du nombre de bosons dans l'oscillateur. Le décalage de fréquence $\chi$ est égal à la différence entre la différence d'énergie entre le niveau excité $|f\rangle$ et le niveau stable $|g\rangle$ pour un nombre k+1 de bosons et la différence d'énergie entre le niveau excité $|f\rangle$ et le niveau stable $|g\rangle$ pour un nombre k de bosons. Le décalage de fréquence $\chi$ peut être positif ou négatif.

Le dispositif auxiliaire 201 peut permettre une action qui dépend de la parité du nombre de bosons.

Le hamiltonien dispersif peut être représenté comme suit :

$$H_d = \hbar\chi a^+ a |f\rangle\langle f|$$

Où $a$ et $a^+$ sont les opérateurs de création et d'annihilation de l'oscillateur harmonique quantique vérifiant $[a, a^+] = 1$.

Le système 200 comprend aussi un dissipateur 203, comportant au moins deux niveaux ou états, dont l'un, le niveau ou état $|0\rangle$, est stable et l'autre, le niveau ou état $|1\rangle$ est un état excité relaxe spontanément vers $|0\rangle$. La différence d'énergie entre ces deux états correspond à une fréquence de transition $\omega_{dis}$ entre les états $|0\rangle$ et $|1\rangle$. La relaxation (ou désexcitation) spontanée du niveau $|1\rangle$ vers le niveau $|0\rangle$ se produit avec un taux de désexcitation $\gamma_{dis}$, qui est égal à la probabilité de passer du niveau $|1\rangle$ vers le niveau $|0\rangle$ par unité de temps.

La relaxation spontanée du niveau $|1\rangle$ vers le niveau $|0\rangle$ peut permettre de rendre, au cours du protocole de correction, des déplacements de population irréversibles.

Chaque niveau d'énergie du système 200 est noté $|k, \psi, n\rangle$ et dépend :

- du niveau d'énergie $|k\rangle$ de l'oscillateur harmonique quantique 202, k désignant le nombre de bosons de l'oscillateur harmonique quantique,
- du niveau d'énergie $|\psi\rangle$ du dispositif auxiliaire 201, $|\psi\rangle$ désignant le niveau stable $|g\rangle$ ou le niveau excité $|f\rangle$, et
- du niveau d'énergie $|n\rangle$ du dissipateur 203, $|n\rangle$ désignant le niveau stable $|0\rangle$ ou le niveau $|1\rangle$.

Le système 200 comprend également un excitateur 204 configuré pour créer deux peignes de fréquences 205 et 206. Il n'est pas nécessaire de prendre en compte l'état de l'excitateur 204 pour caractériser l'état quantique du système 200 qui permet de porter l'information dans le protocole.

Les peignes de fréquences 205 et 206 générés par l'excitateur 204 sont envoyés vers au moins l'un de l'oscillateur harmonique quantique 202, du dispositif auxiliaire non-linéaire 201 et du dissipateur 203.

Les peignes de fréquence sont en résonance avec certaines transitions des niveaux d'énergie du système 200 de sorte à ajouter un boson dans l'oscillateur harmonique si l'entier k n'a pas la parité prédéterminée.

L'écart fréquentiel séparant deux raies successives du premier peigne de fréquences est égal au double d'un deuxième écart fréquentiel séparant deux raies successives du deuxième peigne.

De cette manière, il est possible de séparer temporellement l'action du premier peigne et l'action du deuxième peigne. En particulier, cela permet un contrôle plus fin des transferts de population entre les différents niveaux d'énergie du système 200. Cela diminue le canal d'altération 102. Le canal d'altération est même potentiellement complètement supprimé en l'absence d'autres effets parasites comme, par exemple, les excitations thermiques du dispositif auxiliaire.

*Architecture de niveaux et peignes de fréquences*

Le système 200 peut être configuré pour être, pour chaque entier k d'un ensemble d'entiers, dans :

- un premier niveau défini par un premier nombre de bosons égal à l'entier k, l'état fondamental |g> et l'état fondamental |0>,
- un deuxième niveau défini par un deuxième nombre de bosons égal à l'entier k+1, l'état fondamental |g> et l'état fondamental |0>,
- un troisième niveau dans lequel le dispositif auxiliaire est dans l'état excité |f> et le dissipateur est dans l'état stable |0>,
- un quatrième niveau dans lequel le dispositif auxiliaire est dans l'état fondamental |g> et le dissipateur est dans l'état excité |1>.

Pour chaque entier k de l'ensemble d'entiers, le troisième niveau est défini par un nombre de bosons égal à l'entier k+p, où p est un entier positif ou négatif.

Pour chaque entier k de l'ensemble d'entiers, le quatrième niveau est défini par un nombre de bosons égal à l'entier k+q, où q est un entier positif ou négatif.

L'excitateur est configuré pour coupler, pour chaque entier k, les premier, troisième et quatrième niveaux si l'entier k n'a pas la parité prédéterminée, de sorte à déplacer le système du premier niveau dans le deuxième niveau.

L'excitateur est configuré pour générer des premier et deuxième peignes de fréquences de sorte que, pour chaque entier k :

- le premier peigne comprend une première raie si l'entier k n'a pas la parité prédéterminée, la première raie ayant une fréquence égale à une fréquence de transition entre les premier et troisième niveaux, et
- le deuxième peigne comprend une deuxième raie ayant une fréquence égale à une fréquence de transition entre les troisième et quatrième niveaux.

L'ensemble d'entiers peut notamment être un intervalle d'entiers qui couvre le nombre moyen de bosons initialement généré dans l'oscillateur harmonique.

L'ensemble d'entiers peut également ne comprendre qu'un seul entier.

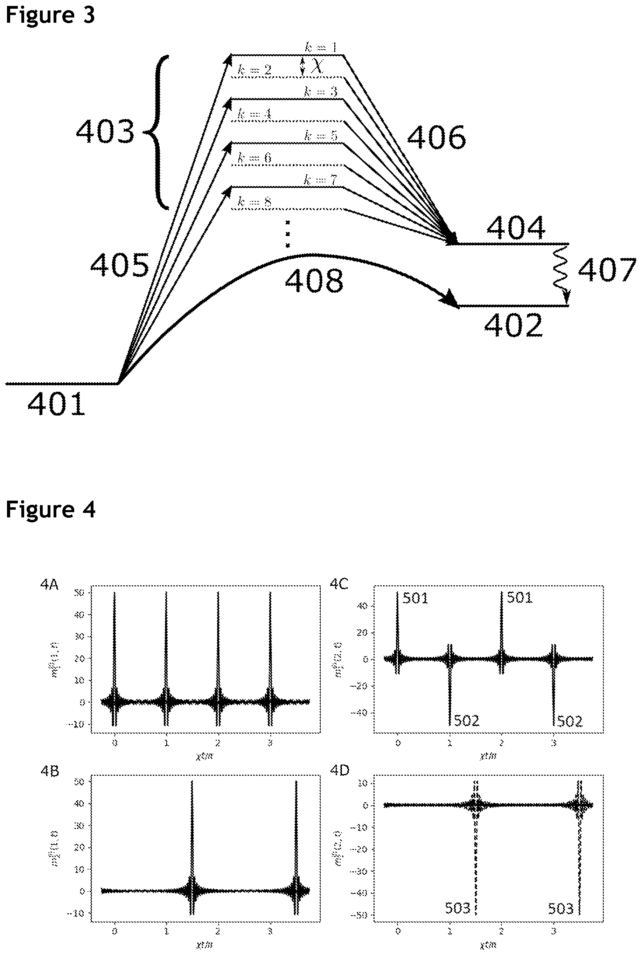

La figure 3 représente schématiquement un exemple d'une telle architecture de niveaux d'énergie du système 200 pour un procédé de stabilisation d'états quantiques. Le niveau d'énergie est représenté verticalement et croissant vers le haut. La figure 3 représente

- le premier niveau ou état $|k, g, 0\rangle$, référencé 401, qui est un état que l'on souhaite conserver si k est pair et corriger en lui ajoutant un boson si k est impair,
- le deuxième niveau ou état $|k + 1, g, 0\rangle$, référencé 402,
- une pluralité de troisièmes niveaux ou états $|k + p, f, 0\rangle$, référencée 403, avec p l'entier positif ou négatif; l'entier p est supposé positif sur la figure 3 ; les niveaux $|k + p, f, 0\rangle$ sont séparés verticalement selon la valeur de k en raison du couplage dispersif entre l'oscillateur harmonique 202 et le dispositif auxiliaire 201 ; le décalage de fréquence $\chi$ est supposé négatif sur cette figure, et sépare verticalement les états $|k + p, f, 0\rangle$ correspondant à deux valeurs successives de k,
- un quatrième niveau ou état $|k + 1, g, 1\rangle$, référencé 404 c'est-à-dire un quatrième niveau pour lequel l'entier q a été choisi égal à 1.

L'excitateur est configuré pour générer :

- un premier peigne de fréquences 405 qui permet des transitions entre le premier niveau 401 et les troisièmes niveaux 403 ; il est configuré pour exciter le dispositif auxiliaire et, éventuellement, décaler de « p » le nombre de bosons de l'oscillateur harmonique quantique ; si p est positif des bosons sont ajoutés par le premier peigne 405, si p est négatif des bosons sont enlevés par ce peigne.
- un deuxième peigne 406 qui permet des transitions entre les troisièmes niveaux 403 et le quatrième niveau 404 ; il est configuré pour désexciter le dispositif auxiliaire, exciter le dissipateur et décaler le nombre de bosons de manière à ce que le quatrième niveau ait un boson supplémentaire par rapport au premier niveau.

L'état $|k+1, g, 1\rangle$ 404 se désexcite spontanément vers l'état $|k+1, g, 0\rangle$ 402 grâce à la relaxation spontanée du niveau $|1\rangle$ vers le niveau $|0\rangle$ selon le taux de désexcitation $\gamma_{dis}$. Cette désexcitation est représentée par une flèche ondulée 407.

L'excitateur génère les premier et deuxième peignes de fréquences de sorte qu'un premier écart fréquentiel séparant deux raies successives du premier peigne de fréquences est égal au double d'un deuxième écart fréquentiel séparant deux raies successives du deuxième peigne.

Le premier écart fréquentiel séparant deux raies successives du premier peigne de fréquences est égal au double du décalage de fréquence $\chi$ et est égal au double du deuxième écart fréquentiel séparant deux raies successives du deuxième peigne.

L'effet de cette différence d'écart fréquentiel est de diminuer le canal d'altération 102 qui correspond à l'ajout de bosons dans l'oscillateur harmonique lorsque celui-ci comprend un nombre de bosons présentant la parité prédéterminée.

Le premier peigne de fréquences 405 comprend des raies de fréquence qui sont en résonance avec les transitions d'un niveau $|k, g, 0\rangle$ 401 à un niveau $|k+p, f, 0\rangle$ 403, uniquement lorsque le niveau $|k, g, 0\rangle$ 401 correspond à un nombre k impair de bosons. Le premier peigne de fréquences 405 est donc configuré pour comprendre des raies de fréquences égales à l'expression $p\omega_{osc} + \omega_{gf} + (k+p)\chi$, avec k impair. Le premier peigne de fréquences est un peigne de fréquences dont les raies sont séparées d'un intervalle fréquentiel égal à $2\chi$. Le deuxième peigne de fréquences 406 comprend des raies de fréquence qui sont en résonance avec les transitions d'un niveau $|k+p, f, 0\rangle$ 403 à un niveau $|k+1, g, 1\rangle$ 404, pour des valeurs du nombre k de bosons pair et impair. Le deuxième peigne de fréquences 406 est donc configuré pour comprendre des raies de fréquences égales à l'expression $\omega_{dis} - (p-1)\omega_{osc} - \omega_{gf} - (k+p)\chi$, avec k pair ou impair. Le deuxième peigne de fréquences est un peigne de fréquences dont les raies sont séparées d'un intervalle fréquentiel égal à $\chi$.

Les peignes de fréquences 405 et 406 permettent de réaliser un déplacement 408 correspondant au canal de correction 101 pour déplacer l'état du système depuis le niveau $|k, g, 0\rangle$ 401 dans le niveau $|k+1, g, 0\rangle$ 402, lorsque $k$ est impair.

Le hamiltonien de couplage correspondant à l'action du premier peigne de fréquences 405 peut être formulé comme suit en représentation interaction :

$$H_1^{(I)} = \hbar \sum_k m_1^{(I)}(k,t) \, a_k |k+p, f, 0\rangle\langle k, g, 0|$$
$$+ \hbar \sum_k \left[ m_1^{(I)}(k,t) \right]^* \, a_k^* |k, g, 0\rangle\langle k+p, f, 0|$$

Le terme $\sum_k$ désigne une somme sur des entiers k.

La fonction $m_1^{(I)}(k,t)$ caractérise l'évolution temporelle en représentation interaction du premier peigne de fréquences 405 généré par l'excitateur 204. Cette fonction dépend du nombre de bosons k car la représentation interaction peut être vue en première approximation comme un changement de référentiel, le référentiel dépendant du nombre de bosons k dans l'oscillateur harmonique quantique.

Les coefficients $a_k$ sont des nombres complexes dépendant de la manière dont le premier peigne de fréquences 405 se couple au système 200.

La fonction $m_1^{(I)}(k,t)$ du premier peigne de fréquences 405 peut être formulée sous la forme suivante :

$$m_1^{(I)}(k,t) = \sum_{k'} m_{1,k'} e^{i(k-2k'-1)\chi t}$$

dans laquelle $m_{1,k'}$ est un nombre complexe caractérisant la raie k' du premier peigne. La fréquence de la raie k' du premier peigne est égale à $p\omega_{osc} + \omega_{gf} + (2k' + 1 + p)\chi$. L'amplitude de $m_{1,k'}$ est une fréquence de couplage caractérisant l'amplitude de la raie k' du premier peigne. La phase de $m_{1,k'}$ est une phase caractérisant la phase de la raie k' du premier peigne.

Le terme $\sum_{k'}$ désigne une somme sur l'entier k' qui peut être positif, négatif ou nul.

Le hamiltonien de couplage correspondant à l'action du deuxième peigne de fréquences 406 peut être formulé comme suit en représentation interaction :

$$H_2^{(I)} = \hbar \sum_k m_2^{(I)}(k,t) b_k |k+1, g, 1\rangle\langle k+p, f, 0|$$
$$+ \hbar \sum_k \left[m_2^{(I)}(k,t)\right]^* b_k^* |k+p, f, 0\rangle\langle k+1, g, 1|$$

La fonction $m_2^{(I)}(k,t)$ caractérise l'évolution temporelle en représentation interaction du deuxième peigne de fréquences 406 généré par l'excitateur 204. Cette fonction dépend du nombre de bosons k car la représentation interaction peut être vue en première approximation comme un changement de référentiel, le référentiel dépendant du nombre de bosons k dans l'oscillateur harmonique quantique.

Les coefficients $b_k$ sont des nombres complexes dépendant de la manière dont le deuxième peigne de fréquences 406 se couple au système 200.

La fonction $m_2^{(I)}(k,t)$ du deuxième peigne de fréquences 406 peut être formulée sous la forme suivante :

$$m_2^{(I)}(k,t) = \sum_{k'} m_{2,k'} e^{-i(k-k')\chi t}$$

dans laquelle $m_{2,k'}$ est un nombre complexe caractérisant la raie k' du deuxième peigne. La fréquence de la raie k' du deuxième peigne est égale à $\omega_{dis} - (p-1)\omega_{osc} - \omega_{gf} - (k'+p)\chi$. L'amplitude de $m_{2,k'}$ est une fréquence de couplage caractérisant l'amplitude de la raie k' du deuxième peigne. La phase de $m_{2,k'}$ est une phase caractérisant la phase de la raie k' du deuxième peigne.

L'effet de la différence d'écart fréquentiel entre le premier peigne de fréquences 405 et le deuxième peigne de fréquences 406 peut être compris à partir de la dépendance temporelle en représentation interaction du premier peigne $m_1^{(I)}(k,t)$ et du deuxième peigne $m_2^{(I)}(k,t)$ dans les cas où k=1 et k=2, en rapport avec la figure 4.

La figure 4 comprend quatre graphes 4A, 4B, 4C et 4D, représentant respectivement de manière schématique les fonctions $m_1^{(I)}(1,t)$, $m_2^{(I)}(1,t)$, $m_1^{(I)}(2,t)$ et $m_2^{(I)}(2,t)$. Pour cet exemple et pour simplifier l'étude, il a été supposé que :

$$m_{1,k'} = \begin{cases} 1, \text{si} -50 < 2k' + 1 < 50 \\ 0, \text{sinon} \end{cases}$$

$$m_{2,k'} = \begin{cases} e^{ik'\chi/8}, \text{si} -50 < k' < 50 \\ 0, \text{sinon} \end{cases}$$

La fonction $m_1^{(I)}(1,t)$ permet de comprendre le couplage entre le niveau $|k, g, 0\rangle$ 401 et le niveau $|k+p, f, 0\rangle$ 403, quand k=1, c'est-à-dire dans une situation où k est impair.

La fonction $m_1^{(I)}(2,t)$ permet de comprendre le couplage entre le niveau $|k, g, 0\rangle$ 401 et le niveau $|k+p, f, 0\rangle$ 403, quand k=2, c'est-à-dire dans une situation où k est pair.

La fonction $m_2^{(I)}(1,t)$ permet de comprendre le couplage entre le niveau $|k+p, f, 0\rangle$ 403 et le niveau $|k+1, g, 1\rangle$ 404, quand k=1, c'est-à-dire dans une situation où k est impair.

La fonction $m_2^{(I)}(2,t)$ permet de comprendre le couplage entre le niveau $|k+p, f, 0\rangle$ 403 et le niveau $|k+1, g, 1\rangle$ 404, quand k=2, c'est-à-dire dans une situation où k est pair.

Dans ces graphes 4A-4D, les lignes continues représentent la partie réelle et les lignes tiretées la partie imaginaire des fonctions $m_1^{(I)}(1,t)$, $m_1^{(I)}(2,t)$, $m_2^{(I)}(1,t)$ et $m_2^{(I)}(2,t)$.

Si dans le domaine fréquentiel un peigne de fréquences est constitué de raies régulièrement séparées par un écart fréquentiel, dans le domaine temporel ce peigne de fréquences est constitué de pics séparés par un écart temporel inversement proportionnel à l'écart fréquentiel. On utilise le terme de raie pour le domaine fréquentiel et le terme de pic pour le domaine temporel.

Dans le graphe 4A, la partie réelle de $m_1^{(I)}(1,t)$ présente des pics régulièrement espacés par un intervalle de temps égal à $\frac{\pi}{\chi}$. Il s'agit des pics composant le premier peigne de fréquences dans sa représentation temporelle. Les pics successifs sont identiques.

L'effet associé à chaque pic de $m_1^{(I)}(1,t)$ est de transférer une partie de la population du premier niveau $|k, g, 0\rangle$ 401 dans le troisième niveau $|k+p, f, 0\rangle$ 403.

Dans le graphe 4B, la partie réelle de $m_2^{(I)}(1,t)$ présente des pics régulièrement espacés par un intervalle de temps égal à $\frac{2\pi}{\chi}$. Il s'agit des pics composant le deuxième peigne de fréquences dans sa représentation temporelle. Les pics successifs sont identiques.

L'effet associé à chaque pic de $m_2^{(I)}(1,t)$ est de transférer une partie de la population du troisième niveau $|k+p, f, 0\rangle$ 403 au quatrième niveau $|k+1, g, 1\rangle$ 404.

L'effet combiné des pics de $m_1^{(I)}(1,t)$ et $m_2^{(I)}(1,t)$ est, comme attendu, de réaliser le canal de correction 101, c'est-à-dire ajouter un boson dans l'oscillateur harmonique quand initialement celui-ci contient un nombre impair de bosons, en l'occurrence un nombre impair égal à un.

Dans le graphe 4C, la partie réelle de $m_1^{(I)}(2,t)$ présente des pics régulièrement espacés par un intervalle de temps égal à $\frac{\pi}{\chi}$. Contrairement aux pics de $m_1^{(I)}(1,t)$ qui sont tous de même signe, les pics de $m_1^{(I)}(2,t)$ ont des signes alternés. Plus précisément deux pics successifs (501 et 502 sur la figure 5) présentent des signes différents.

Dans le graphe 4D, la partie imaginaire de $m_2^{(I)}(2,t)$ présente des pics 503 régulièrement espacés par un intervalle de temps égal à $\frac{2\pi}{\chi}$.

L'effet associé à chaque pic positif 501 de $m_1^{(I)}(2,t)$ est d'effectuer un transfert d'une partie de la population du premier niveau $|k, g, 0\rangle$ 401 dans le troisième niveau $|k+p, f, 0\rangle$ 403, et l'effet associé à chaque pic négatif 502 de $m_1^{(I)}(2,t)$ est d'effectuer le transfert exactement opposé, au sens d'une rotation d'angle exactement opposé dans la sphère de Bloch, d'une partie de la population du troisième niveau $|k+p, f, 0\rangle$ 403 dans le premier niveau $|k, g, 0\rangle$ 401.

L'effet associé à chaque pic 503 de $m_2^{(I)}(2,t)$ est d'effectuer un transfert d'une partie de la population du troisième niveau $|k+p, f, 0\rangle$ 403 au quatrième niveau $|k+1, g, 1\rangle$ 404.

Dans le cas de la figure 4, $m_1^{(I)}(2,t)$ présente un écart entre ses pics égal à $\frac{\pi}{\chi}$, alors que $m_2^{(I)}(2,t)$ présente un écart entre ses pics égal à $\frac{2\pi}{\chi}$. Cet écart temporel double est la conséquence du fait que les raies du premier peigne de fréquences 405 sont espacées d'un écart en fréquence égal au double de l'écart en fréquence des raies du deuxième peigne de fréquences 406. De cette manière, un couple pic positif 501 / pic négatif 502 de $m_1^{(I)}(2,t)$ se trouve

toujours entre deux pics successifs 503 de $m_2^{(I)}(2,t)$. Ainsi, l'action du premier pic positif 501 du premier peigne est annulée par l'action du deuxième pic négatif 502. Comme il n'y a pas de pic 503 du deuxième peigne sur l'intervalle de temps séparant ces deux pics du premier peigne, le deuxième peigne n'interfère pas avec le premier peigne sur cet intervalle. Cela permet de diminuer le canal d'altération 102. Le canal d'altération est même potentiellement complètement supprimé en l'absence d'autres effets parasites comme, par exemple, les excitations thermiques du dispositif auxiliaire.

*Décalage temporel entre les peignes de fréquences*

Il est possible de configurer l'excitateur de sorte qu'il génère le premier et le deuxième peignes de fréquences avec les pics du premier peigne décalés temporellement par rapport aux pics du deuxième peigne.

L'écart fréquentiel séparant deux raies successives du premier peigne de fréquences est égal à $2\chi$ et l'écart fréquentiel séparant deux raies successives du deuxième peigne est égal à $\chi$.

Le décalage temporel peut être caractérisé par la durée D séparant un pic négatif 502 du premier peigne de fréquences 405 et le premier pic 503 du deuxième peigne de fréquence 406 qui suit temporellement le pic négatif 502.

Le décalage temporel D peut être choisi librement dans l'intervalle $\left[0; \dfrac{2\pi}{\chi}\right]$. Le décalage temporel D peut être avantageusement choisi dans l'intervalle $\left[\dfrac{\delta_1+\delta_2}{2}; \dfrac{\pi}{\chi} - \dfrac{\delta_1+\delta_2}{2}\right]$ ou l'intervalle $\left[\dfrac{\pi}{\chi} + \dfrac{\delta_1+\delta_2}{2}; \dfrac{2\pi}{\chi} - \dfrac{\delta_1+\delta_2}{2}\right]$ où $\delta_1$ et $\delta_2$ désignent respectivement la largeur à mi-hauteur des pics du premier peigne et du deuxième peigne.

Comme précédemment présenté, si l'écart fréquentiel du premier peigne est le double de l'écart fréquentiel du deuxième peigne, alors il y a un écart entre pics de la fonction $m_2^{(I)}(k,t)$ double de celui de la fonction $m_1^{(I)}(k,t)$.

Si les pics du premier peigne de fréquences 405 sont décalés temporellement par rapport aux pics du deuxième peigne de fréquences 406, alors il n'y a pas de coïncidence temporelle entre un pic du premier peigne de fréquences 405 et un pic du deuxième peigne de fréquences 406. De cette manière, il n'y a pas de pic 503 du deuxième peigne de fréquences 406 sur l'intervalle de temps séparant un pic 501 du pic suivant 502 du premier peigne de fréquences 405. L'effet du pic 501 du premier peigne de fréquences 405 est annulé par l'effet du pic suivant 502 du premier peigne de fréquences 405, de sorte qu'à l'arrivée du pic 503 du deuxième peigne de fréquences 406, il n'y a aucune population dans le niveau $|k + p, f, 0\rangle$ 343 que ce pic peut transférer vers le niveau $|k + 1, g, 1\rangle$ 404 lorsque le nombre de bosons k est pair.

Sans coïncidence temporelle entre un pic du premier peigne de fréquences 405 et un pic du deuxième peigne de fréquences 406, il n'est pas possible non plus qu'il y ait un transfert de population du niveau $|k, g, 0\rangle$ 401 vers le niveau $|k + p, f, 0\rangle$ 403 par le pic du premier peigne qui soit simultanément transféré vers le niveau $|k + 1, g, 1\rangle$ 404 par le pic du deuxième peigne de fréquences 406.

Le canal d'altération 102 est encore diminué par cette caractéristique de non-coïncidence des pics du premier et du deuxième peignes de fréquences.

*Nombre de raies dans les peignes de fréquences*

Comme précédemment décrit, le premier peigne de fréquences 405 comprend des raies de fréquence qui sont en résonance avec les transitions du premier niveau $|k, g, 0\rangle$ 401 au troisième niveau $|k + p, f, 0\rangle$ 403, uniquement lorsque le niveau $|k, g, 0\rangle$ 401 correspond à un nombre k impair de bosons. Ces raies se trouvent aux fréquences $p\omega_{osc} + \omega_{gf} + (2k' + 1 + p)\chi$ où $k'$ est un entier numérotant la raie. Elles sont séparées d'un intervalle fréquentiel égal à $2\chi$.

Si le code de correction d'erreur requiert que soient stabilisés les états de Fock de parité paire ayant un nombre de bosons compris entre un entier plancher pair $k_{min}$ et un entier plafond pair $k_{max}$, alors l'ensemble d'entiers est égal aux entiers compris entre les entiers $k_{min}$ - 1 et $k_{max}$ - 1.

Dans ce cas, le premier peigne de fréquences 405 doit comprendre au minimum les raies correspondant aux entiers $k'$, tels que $2k' + 1 = k_{min} - 1, k_{min} + 1, ... k_{max} - 3, k_{max} - 1$.

C'est notamment le cas lorsque l'information est encodée dans des états de l'oscillateur correspondant à un nombre de bosons compris entre un entier plancher pair $k_{min}$ et un entier plafond pair $k_{max}$.

Le premier peigne de fréquences 405 peut comprendre avantageusement davantage de raies et notamment comprendre les raies $k'$, tels que $2k' + 1 = k_1, k_1 + 2, ..., k_2 - 2, k_2$ où $k_1$ est un entier impair inférieur à $k_{min}$ - 1 et $k_2$ est un entier impair supérieur à $k_{max}$ - 1. Le nombre $k_1$ peut être négatif.

De cette manière, le premier peigne de fréquences 405 ne comprend aucune raie résonante entre le premier niveau 401 et la pluralité de troisièmes niveaux 403 lorsque le nombre de bosons k du premier niveau 401 est pair.

Plus le nombre de raies comprises dans le premier peigne de fréquences 405 est important et meilleure est la définition des pics 501 et 502 de sa représentation dans le domaine temporel. Cela permet notamment de faciliter et améliorer la condition de non-coïncidence entre les pics 501 et 502 du premier peigne de fréquences 405 et les pics 503 du deuxième peigne de fréquences 406.

Comme précédemment décrit, le deuxième peigne de fréquences 406 comprend des raies de fréquence qui sont en résonance avec les transitions du troisième niveau $|k + p, f, 0\rangle$ 403 au quatrième niveau $|k + 1, g, 1\rangle$ 404, lorsque le nombre k est pair ou impair. Ces raies se trouvent aux fréquences $\omega_{dis}$ - $(p - 1)\omega_{osc}$ - $\omega_{gf}$ - $(k' + p)\chi$ où $k'$ est un entier numérotant la raie. Elles sont séparées d'un intervalle fréquentiel égal à $\chi$.

Si le code de correction d'erreur requiert que soient stabilisés les états de Fock de parité paire ayant un nombre de bosons compris entre l'entier plancher pair $k_{min}$ et l'entier plafond pair $k_{max}$, alors le deuxième peigne de fréquences 406 doit comprendre au minimum les raies $k' = k_{min}$ - 1, $k_{min}$, ..., $k_{max}$ - 2, $k_{max}$ - 1. Le deuxième peigne de fréquences 406 peut comprendre avantageusement davantage de raies et notamment comprendre les raies $k' = k_3, k_3 + 1, ..., k_4 - 1, k_4$ où $k_3$ est un entier pair ou impair inférieur à $k_{min}$ - 1 et $k_4$ est un entier pair ou impair supérieur à $k_{max}$ - 1. Le nombre $k_3$ peut être négatif.

De cette manière, le deuxième peigne de fréquences 406 comprend toujours des pics 503 temporels espacés d'un écart temporel double de l'écart temporel entre les pics 501 et 502 du premier peigne de fréquences 405. Plus le nombre de raies dans le deuxième peigne de fréquences 406 est important et meilleure est la définition des pics 503 de sa représentation dans le domaine temporel. Cela permet notamment de faciliter et améliorer la condition de non-coïncidence entre les pics 501 et 502 du premier peigne de fréquences 405 et les pics 503 du deuxième peigne de fréquences 406.

*Amplitude des raies des peignes de fréquences*

Chaque pic 501, 502 du premier peigne de fréquences 405 ou chaque pic 503 du deuxième peigne de fréquence 406 engendre un transfert de population entre des niveaux de l'architecture telle qu'on a pu les présenter plus haut. Un régime intéressant est obtenu lorsque le transfert engendré par les deux pics successifs 501 et 502 et le transfert engendré par le pic 503 correspondent chacun à une rotation dans la sphère de Bloch dont l'angle est plus petit que $\pi$.

Ce régime correspond à avoir des peignes dont les fréquences de couplage $|m_{1,k'}|$ et $|m_{2,k'}|$ caractérisant les amplitudes des raies de fréquence sont plus petites que le quart du deuxième écart fréquentiel séparant deux raies successives du deuxième peigne de fréquences 406.

Ce régime étant caractérisé par des raies ayant de petites amplitudes, donc par un excitateur envoyant des peignes ayant une puissance réduite, il est plus aisé à réaliser expérimentalement et est moins susceptible de provoquer des effets indésirables comme un échauffement du système, la saturation de ses composants non-linéaires ou l'apparition d'harmoniques.

De plus, il existe dans ce régime un unique maximum du temps de vie des états ayant un nombre pair de bosons en fonction des fréquences de couplage $|m_{1,k'}|$ et $|m_{2,k'}|$.

En effet, augmenter ces fréquences permet d'augmenter le taux de transfert effectif 408 du premier niveau 401 au deuxième niveau 402 lorsque le nombre de bosons k dans le premier niveau est impair. Cela résulte en une augmentation du taux de correction du processus de correction 101.

Cependant, comme cela a été précédemment mentionné, les imperfections expérimentales peuvent rendre non nul le taux de transfert effectif 408 du premier au deuxième niveau lorsque le nombre de bosons k dans le premier niveau est pair. Dans ce cas, augmenter les fréquences de couplage $|m_{1,k'}|$ et $|m_{2,k'}|$ résulte aussi en une augmentation du taux d'altération du processus d'altération 102.

Il a été mentionné que le processus d'altération 102 pouvait ne pas être corrigé par le processus de correction 101, mais au contraire aggravé.

Dans le régime où les fréquences de couplage $|m_{1,k'}|$ et $|m_{2,k'}|$ sont plus petites que $\frac{\chi}{4}$, il existe ainsi un réglage optimal de l'amplitude des raies correspondant à un maximum unique du temps de vie des états ayant un nombre pair de bosons. Le fait que ce maximum soit unique permet de trouver à coup sûr le réglage optimal, aussi bien expérimentalement que théoriquement, par un algorithme d'optimisation comme, par exemple, l'algorithme du gradient.

Une telle optimisation de l'amplitude des raies des premier et deuxième peignes de fréquences, l'amplitude des raies étant caractérisée par une fréquence de couplage, peut notamment être réalisée par les étapes suivantes :

- (E1) choisir une valeur de fréquence de couplage inférieure au quart du deuxième écart fréquentiel,
- (E2) mesurer un temps de vie des états ayant un nombre pair de bosons,
- (E3) modifier la valeur de la fréquence de couplage en fonction du temps de vie mesuré selon un algorithme d'optimisation du temps de vie de sorte à identifier une valeur optimale de la fréquence de couplage correspondant à un maximum du temps de vie.

Un exemple d'algorithme d'optimisation consiste à suivre les étapes suivantes :

- (F1) choisir un entier a supérieur à 2 et calculer un écart de fréquence de couplage égal au rapport du quart du deuxième écart fréquentiel sur l'entier a,
- (F2) réaliser une boucle de sous-étapes indicées par l'entier i initialement égal à un :

  - (F21) calculer une valeur FC(i) de fréquence du couplage égale au produit de l'entier i par l'écart de fréquence de couplage, les premier et deuxième peigne de fréquences générés et envoyés vers au moins l'un parmi l'oscillateur harmonique quantique, le dispositif auxiliaire et le dissipateur, présentant une amplitude des raies caractérisée par la valeur de fréquence de couplage calculée,
  - (F22) mesurer un temps de vie TV(i) des états de l'oscillateur ayant un nombre pair de bosons,
  - (F23) si i est égal à 1 remplacer l'entier i par l'entier i+1 et répéter les étapes F21 et F22, sinon
  - (F24) lorsque TV(i-1) est inférieur à TV(i), remplacer l'entier i par l'entier i+1 et répéter les étapes F21 à F24, sinon
  - (F3) arrêter la boucle de sous-étapes et restituer sur une interface la valeur FC(i-1) de fréquence du couplage correspondant à un temps de vie maximum TV(i-1) des états de l'oscillateur.

L'interface peut notamment être une interface d'entrée et de sortie permettant la saisie des données ou de restituer les résultats d'un procédé.

Il est à noter que plus l'entier a est important et meilleure est la précision de la fréquence du couplage recherchée correspondant au temps de vie maximum. Cependant, au moins en raison de l'erreur de mesure du temps de vie, il existe un entier a au-delà duquel l'application des étapes précédentes n'améliore la précision sur la fréquence du couplage recherchée.

*Taux de relaxation du dissipateur*

Le taux de transfert effectif 308 est ultimement limité par le taux de désexcitation $\gamma_{dis}$, égal à la probabilité de passer du niveau $|1\rangle$ du dissipateur vers le niveau $|0\rangle$ par unité de temps. Il en résulte que le taux de correction $\gamma_{up}$ est nécessairement inférieur au taux de désexcitation $\gamma_{dis}$.

Augmenter $\gamma_{dis}$ peut donc permettre d'augmenter le taux de correction $\gamma_{up}$.

Cependant, en vertu de la relation d'incertitude temps.énergie de Heisenberg, augmenter $\gamma_{dis}$ entraîne un élargissement du troisième niveau 403 proportionnel à $\hbar\gamma_{dis}/2$. Lorsque cet élargissement est de l'ordre de la quantité $\hbar\chi$, les niveaux correspondant à un nombre de bosons pair ou impair se recouvrent.

Ce recouvrement peut potentiellement augmenter le taux d'altération $\overline{\gamma_{up}}$ et nuire à la sélectivité.

Dans le régime mentionné précédemment où les fréquences de couplage $|m_{1,k}|$ et $|m_{2,k}|$ sont plus petites que le quart du deuxième écart fréquentiel séparant deux raies successives du deuxième peigne de fréquences 406, l'augmentation simultanée du taux de correction $\gamma_{up}$ et du taux d'altération $\overline{\gamma_{up}}$ avec $\gamma_{dis}$ résulte en l'existence d'un unique maximum du temps de vie des états ayant un nombre pair de bosons en fonction de $\gamma_{dis}$.

Le fait que ce maximum soit unique permet de trouver à coup sûr la valeur optimale de $\gamma_{dis}$, aussi bien expérimentalement que théoriquement, par un algorithme d'optimisation comme, par exemple, l'algorithme du gradient.

Une telle optimisation du taux de désexcitation $\gamma_{dis}$ peut notamment être réalisée par la réalisation des étapes suivantes :

- (S1) choisir une valeur du taux de désexcitation inférieure au deuxième écart fréquentiel,
- (S2) mesurer un temps de vie des états ayant un nombre pair de bosons,
- (S3) modifier la valeur du taux de désexcitation en fonction du temps de vie mesuré selon un algorithme d'optimisation du temps de vie de sorte à identifier une valeur optimale du taux de désexcitation correspondant à un maximum du temps de vie.

Un exemple d'algorithme d'optimisation consiste à suivre les étapes suivantes :

- (T1) choisir un entier b supérieur à 2 et calculer un écart de taux de désexcitation égal au rapport du deuxième écart fréquentiel sur l'entier b,
- (T2) réaliser une boucle de sous-étapes indicées par l'entier i initialement égal à un :

  - (T21) calculer une valeur TD(i) du taux de désexcitation égale au produit de l'entier i par l'écart de taux de désexcitation, le dispositif auxiliaire étant couplé au dissipateur configuré pour passer d'un état excité $|1\rangle$ dans un état fondamental $|0\rangle$ selon un taux de désexcitation égal à la valeur TD(i),
  - (T22) mesurer un temps de vie TV(i) des états de l'oscillateur ayant un nombre pair de bosons,

- **(T23)** si i est égal à 1 remplacer l'entier i par l'entier i+1 et répéter les étapes T21 et T22, sinon
- **(T24)** lorsque TV(i-1) est inférieur à TV(i), remplacer l'entier i par l'entier i+1 et répéter les étapes T21 à T24, sinon
- **(T3)** arrêter la boucle de sous-étapes et restituer sur une interface la valeur TD(i-1) du taux de désexcitation correspondant à un temps de vie maximum TV(i-1) des états de l'oscillateur

L'interface peut notamment être l'interface précédemment évoqué pour la recherche de la fréquence de couplage correspondant au temps de vie maximum. Il est à noter que plus l'entier b est important et meilleure est la précision du taux de désexcitation recherché correspondant au temps de vie maximum. Cependant, au moins en raison de l'erreur de mesure du temps de vie, il existe un entier b au-delà duquel l'application des étapes précédentes n'améliore la précision sur le taux de désexcitation recherché.

## Autres architectures de niveaux possibles

Il a été proposé jusqu'à présent d'utiliser le premier niveau ou état $|k, g, 0\rangle$ référencé 401, une pluralité de troisièmes niveaux ou états $|k + p, f, 0\rangle$, référencée 403, un quatrième niveau $|k + 1, g, 1\rangle$, référencé 404, et un deuxième niveau $|k + 1, g, 0\rangle$, référencé 402.

Plus généralement, il est possible d'utiliser un quatrième niveau comportant un nombre de bosons k+q différent de k+1, avec q un entier positif ou négatif. Lorsque l'entier q est différent de 1, le passage de l'état |1> à l'état |0> du dissipateur avec le taux $\gamma_{dis}$ s'accompagne alors d'un décalage q-1 du nombre de bosons.

Dans ce cas, les fréquences des raies du deuxième peigne sont égales à $\omega_{dis} - (p - q)\omega_{osc} - \omega_{gf} - (k' + p)\chi$ où k' est un entier.

## Technologie des circuits supraconducteurs

Le procédé de stabilisation décrit ici peut, par exemple, être réalisé en utilisant la technologie des circuits supraconducteurs.

L'oscillateur harmonique quantique peut alors être un résonateur micro-onde supraconducteur.

Le système auxiliaire peut être un transmon.

Le dissipateur peut être un autre résonateur micro-onde supraconducteur ayant, comparativement à l'oscillateur, un mauvais facteur de qualité.

Dans ce cas, le hamiltonien du système peut être écrit de la manière suivante :

$$H = \hbar\omega_{osc}a^+a + \hbar\omega_0 b^+b - \frac{\hbar K}{2}b^+b^+bb + \hbar\chi_0 a^+ab^+b + \hbar\omega_{dis}c^+c$$

où $\omega_{osc}$ est la fréquence de résonance du résonateur micro-onde supraconducteur jouant le rôle de l'oscillateur harmonique quantique encodant le qubit logique ; $a, a^+$ sont ses opérateurs de création et annihilation vérifiant $[a, a^+]$ = 1 ; $\omega_0$ est la fréquence de transition fondamentale du transmon ; K son anharmonicité ; $b, b^+$ sont ses opérateurs de création et annihilation vérifiant $[b, b^+]$ = 1 ; $\omega_{dis}$ est la fréquence de résonance du résonateur micro-onde supraconducteur jouant le rôle du dissipateur; $c, c^+$ sont ses opérateurs de création et annihilation vérifiant $[c, c^+]$ = 1 ; $\chi_0$ est un décalage de fréquence du premier niveau excité du transmon par boson ajouté dans l'oscillateur harmonique quantique.

De plus, les opérateurs des trois composantes du système tripartite commutent :

$$[a, b] = [a^+, b^+] = [a, b^+] = [a^+, b] = [a, c] = [a^+, c^+] = [a, c^+] = [a^+, c] = [c, b]$$
$$= [c^+, b^+] = [c, b^+] = [c^+, b] = 0$$

Le processus de relaxation 100 de l'oscillateur harmonique quantique et le processus de désexcitation 407 du dissipateur peuvent être décrits, respectivement, par les opérateurs sauts suivants :

$$L_{osc} = \sqrt{\gamma_{osc}}a, \qquad L_{dis} = \sqrt{\gamma_{dis}}c$$

Où $\gamma_{osc}$ est le taux de relaxation et $\gamma_{dis}$ est le taux de désexcitation.

L'état $|k\rangle$ de l'oscillateur harmonique quantique correspond à l'état contenant k photons dans le résonateur micro-onde supraconducteur. Les états $|0\rangle$ et $|1\rangle$ du dissipateur correspondent aux états contenant respectivement 0 et 1 photon dans le résonateur micro-onde supraconducteur ayant un mauvais facteur de qualité. L'état $|g\rangle$ du dispositif auxiliaire correspond à l'état fondamental du transmon ($b^+b|g\rangle$ = 0). L'état $|f\rangle$ peut correspondre à un état excité parmi plusieurs états excités du transmon.

Il est possible d'obtenir différents modes de réalisation en faisant varier :

- l'état excité du transmon choisi pour jouer le rôle de l'état $|f\rangle$ et
- la valeur de l'entier $p$ qui définit la pluralité des troisièmes niveaux ou états $|k + p, f, 0\rangle$.

La table 1 liste trois modes de réalisation correspondant à un couple particulier d'état excité $|f\rangle$ et d'entier $p$. Une fois ce couple fixé, il est possible de déduire, pour chaque mode les expressions des termes $h_1$, $h_2$, $c_k$, $d_k$, $p$, $\omega_{gf}$ et $\chi$. Ces termes ont été introduits précédemment à l'exception des termes $h_1$ et $h_2$ qui sont tels que $H_1 = g_1(t)h_1 + g_1^*(t)h_1^+$ et que $H_2 = g_2(t)h_2 + g_2^*(t)h_2^+$, avec $g_1(t)$ et $g_2(t)$ les fonctions définissant respectivement les premier et deuxième peignes de fréquences en représentation de Schrödinger.

*Table 1 : Exemples de modes de réalisation de l'architecture de niveaux pour le protocole de stabilisation de parité*

|  | Mode 1 | Mode 2 | Mode 3 |
|---|---|---|---|
| Niveau excité du transmon $|f\rangle$ | $b^+b|f\rangle_1 = 2|f\rangle_1$ | $b^+b|f\rangle_2 = |f\rangle_2$ | $b^+b|f\rangle_3 = |f\rangle_3$ |
| $p$ | 1 | 1 | 0 |
| q | 1 | 1 | 1 |
| $h_1$ | $a^+b^+b^+$ | $a^+b^+$ | $b^+$ |
| $h_2$ | $bbc^+$ | $bc^+$ | $a^+bc^+$ |
| $c_k$ | $\sqrt{2(k+1)}$ | $\sqrt{k+1}$ | 1 |
| $d_k$ | $\sqrt{2}$ | 1 | $\sqrt{k+1}$ |
| $\omega_{gf}$ | $2\omega_0 - K$ | $\omega_0$ | $\omega_0$ |
| $\chi$ | $2\chi_0$ | $\chi_0$ | $\chi_0$ |

L'état excité $|f\rangle$ est défini dans la table 1 comme état propre de l'opérateur $b^+b$.

Il est possible, en choisissant d'autres couples état excité $|f\rangle$ / entier $p$, de déterminer d'autres modes de réalisation.

Selon l'expression du $h_1$ et du $h_2$ obtenue par le choix du couple état excité $|f\rangle$ / entier $p$, le mode de réalisation est plus ou moins simple à réaliser.

Dans le cas où l'expression d'un opérateur $h_1$ ou $h_2$ fait intervenir le produit d'un ou de trois opérateurs de création et d'annihilation $a$, $a^+$, $b$, $b^+$, $c$ et $c^+$, cet opérateur peut être réalisé en générant par l'excitateur un signal micro-onde excitant le transmon (voir par exemple le document précédemment cité de GERTLER Jeffrey M. et PECHAL M. et al. "Microwave-Controlled Generation of Shaped Single Photons in Circuit Quantum Electrodynamics" Physical Review X, Vol. 4, page 041010) et ayant des raies aux fréquences :

$p\omega_{osc} + \omega_{gf} + (2k' + 1 + p)\chi$ pour un opérateur $h_1$ c'est-à-dire pour le premier peigne et
$\omega_{dis} - (p - 1)\omega_{osc} - \omega_{gf} - (k' + p)\chi$ pour un opérateur $h_2$ c'est-à-dire pour le deuxième peigne.

Dans le cas où l'expression d'un opérateur $h_1$ ou $h_2$ fait intervenir le produit de deux opérateurs de création et d'annihilation $a$, $a^+$, $b$, $b^+$, $c$ et $c^+$, cet opérateur peut être réalisé en générant par l'excitateur deux signaux micro-onde excitant le transmon, comme présenté dans CAMPAGNE-IBARCQ P. et al. "Deterministic Remote Entanglement of Superconducting Circuits through Microwave Two-Photon Transitions", Physical Review Letters Vol. 120 page 200501.

Pour un opérateur $h_1$ faisant intervenir le produit de deux opérateurs création et annihilation, les deux signaux micro-onde doivent avoir un produit qui est un signal présentant des raies aux fréquences $p\omega_{osc} + \omega_{gf} + (2k' + 1 + p)\chi$.

Par exemple les deux signaux micro-onde peuvent être :

- d'une part un peigne de fréquences comprenant les raies (où $\Delta$ est une fréquence constante) : $p\omega_{osc} + \omega_{gf} + (2k' + 1 + p)\chi - \Delta$, et
- d'autre part un signal monochromatique à la fréquence $\Delta$.

Pour un opérateur $h_2$ faisant intervenir le produit de deux opérateurs création et annihilation, les deux signaux micro-onde doivent avoir un produit qui est un signal présentant des raies aux fréquences $\omega_{dis} - (p - 1)\omega_{osc} - \omega_{gf} - (k' + p)\chi$. Par exemple les deux signaux micro-onde peuvent être :

- d'une part un peigne de fréquences comprenant les raies (où $\Delta$ est une fréquence constante) : $\omega_{dis} - (p - 1)\omega_{osc} - \omega_{gf} - (k' + p)\chi - \Delta$, et
- d'autre part un signal monochromatique à la fréquence $\Delta$.


**Revendications**

1. Système de stabilisation (200) autonome d'états quantiques comprenant :

   - un oscillateur harmonique quantique (202) configuré pour porter une information encodée dans des états de l'oscillateur ayant une parité prédéterminée d'un nombre de bosons compris dans l'oscillateur harmonique (202),
   - un dispositif auxiliaire (201) configuré pour être dans un état fondamental |g> ou dans un état excité |f> parmi une pluralité d'états excités, le dispositif (201) étant couplé à l'oscillateur (202) de manière dispersive, de sorte qu'une différence de fréquence entre l'état fondamental |g> et l'état excité |f> dépend de manière linéaire d'un décalage de fréquence $\chi$ et du nombre de bosons,
   - un dissipateur (203) configuré pour passer d'un état excité |1> dans un état fondamental |0>,
   - un excitateur (204) configuré pour générer des premier (205, 405) et deuxième (206, 406) peignes de fréquences, destinés à être envoyés vers au moins l'un parmi l'oscillateur harmonique quantique (202), le dispositif auxiliaire (201) et le dissipateur (203) de sorte à ajouter un boson dans l'oscillateur harmonique (202) si le nombre de bosons n'a pas la parité prédéterminée, **caractérisé en ce qu'**un premier écart fréquentiel séparant deux raies successives du premier peigne de fréquences (205, 405) est égal au double du décalage de fréquence $\chi$ et est égal au double d'un deuxième écart fréquentiel séparant deux raies successives du deuxième peigne (206, 406),

   dans lequel les premier et deuxième peignes présentent des pics dans le domaine temporel, les pics du premier peigne étant décalés temporellement par rapport aux pics du deuxième peigne.

2. Système selon la revendication 1 configuré en outre pour être, pour chaque entier k d'un ensemble d'entiers, dans :

   - un premier niveau (401) défini par un premier nombre de bosons égal à l'entier k, l'état fondamental |g> et l'état fondamental |0>,
   - un deuxième niveau (402) défini par un deuxième nombre de bosons égal à l'entier k+1, l'état fondamental |g> et l'état fondamental |0>,
   - un troisième niveau (403) dans lequel le dispositif auxiliaire est dans l'état excité |f> et le dissipateur est dans l'état stable |0>,
   - un quatrième niveau (404) dans lequel le dispositif auxiliaire est dans l'état fondamental |g> et le dissipateur est dans l'état excité |1>, l'excitateur (204) étant configuré pour coupler, pour chaque entier k, les premier, troisième et quatrième niveaux si l'entier k n'a pas la parité prédéterminée, de sorte à déplacer le système du premier niveau (401) dans le deuxième niveau (402), l'excitateur (204) étant configuré pour générer les premier et deuxième peignes de fréquences de sorte que, pour chaque entier k :

     - le premier peigne (405) comprend une première raie si l'entier k n'a pas la parité prédéterminée, la première raie ayant une fréquence égale à une fréquence de transition entre les premier et troisième niveaux, et
     - le deuxième peigne (406) comprend une deuxième raie ayant une fréquence égale à une fréquence de transition entre les troisième et quatrième niveaux.

3. Système selon la revendication 2 dans lequel l'oscillateur harmonique (202) comprend le deuxième nombre de bosons égal à l'entier k+1 dans le quatrième niveau (402).

4. Système selon l'une des revendications 1 à 3 dans lequel l'oscillateur harmonique quantique (202) est un premier résonateur micro-onde supraconducteur, le système auxiliaire (201) est un transmon, le dissipateur (203) est un deuxième résonateur micro-onde supraconducteur ayant un facteur de qualité inférieur à un facteur de qualité du premier résonateur micro-onde supraconducteur.

5. Système selon l'une des revendications 1 à 4 dans lequel une amplitude des raies du premier peigne de fréquences et du deuxième peigne de fréquences est **caractérisée par** une fréquence de couplage, la fréquence de couplage étant inférieure au quart du deuxième écart fréquentiel.

6. Système selon la revendication 2 ou 3 dans lequel l'information est encodée dans des états de l'oscillateur correspondant à un nombre de bosons compris entre un entier plancher $k_{min}$ ayant la parité prédéterminée et un entier plafond $k_{max}$ ayant la parité prédéterminée, l'ensemble d'entiers étant égal aux entiers compris entre les entiers $k_{min}$ - 1 et $k_{max}$ - 1.

7. Procédé de stabilisation autonome d'états quantiques comprenant les étapes suivantes :

- encoder une information dans des états d'un oscillateur harmonique quantique, les états ayant une parité prédéterminée d'un nombre de bosons compris dans l'oscillateur harmonique,
- coupler de manière dispersive l'oscillateur harmonique à un dispositif auxiliaire, de sorte qu'une différence de fréquence entre un état fondamental |g> du dispositif auxiliaire et un état excité |f> du dispositif auxiliaire dépend de manière linéaire d'un décalage de fréquence $\chi$ et du nombre de bosons,
- coupler le dispositif auxiliaire à un dissipateur configuré pour passer d'un état excité |1> dans un état fondamental |0>,
- générer des premier et deuxième peignes de fréquences, un premier écart fréquentiel séparant deux raies successives du premier peigne de fréquences étant égal au double du décalage de fréquence $\chi$ et égal au double d'un deuxième écart fréquentiel séparant deux raies successives du deuxième peigne et
- envoyer les premier et deuxième peignes de fréquences vers au moins l'un parmi l'oscillateur harmonique quantique, le dispositif auxiliaire et le dissipateur de sorte à ajouter un boson dans l'oscillateur harmonique si le nombre de bosons n'a pas la parité prédéterminée,

dans lequel les premier et deuxième peignes présentent des pics dans le domaine temporel, les pics du premier peigne étant décalés temporellement par rapport aux pics du deuxième peigne.

8. Procédé selon la revendication 7 comprenant en outre une optimisation de l'amplitude des raies des premier et deuxième peignes de fréquences, l'amplitude des raies étant **caractérisée par** une fréquence de couplage, comprenant les étapes suivantes :

- (E1) choisir une valeur de fréquence de couplage inférieure au quart du deuxième écart fréquentiel,
- (E2) mesurer un temps de vie des états ayant un nombre de bosons de la parité prédéterminée et
- (E3) modifier la valeur de la fréquence de couplage en fonction du temps de vie mesuré selon un algorithme d'optimisation du temps de vie de sorte à identifier une valeur optimale de la fréquence de couplage correspondant à un maximum du temps de vie.

9. Procédé selon la revendication 7 comprenant en outre une optimisation d'un taux de désexcitation $\gamma_{dis}$ égal à la probabilité de passer du niveau |1⟩ vers le niveau |0⟩ par unité de temps, comprenant les étapes suivantes :

- (51) choisir une valeur du taux de désexcitation inférieure au deuxième écart fréquentiel,
- (S2) mesurer un temps de vie des états ayant un nombre de bosons de la parité prédéterminée et
- (S3) modifier la valeur du taux de désexcitation en fonction du temps de vie mesuré selon un algorithme d'optimisation du temps de vie de sorte à identifier une valeur optimale du taux de désexcitation correspondant à un maximum du temps de vie.

**Patentansprüche**

1. System zur autonomen Stabilisierung (200) von Quantenzuständen, umfassend:

- einen harmonischen Quantenoszillator (202), der konfiguriert ist, um eine codierte Information in Zuständen des Oszillators zu tragen, die eine vorbestimmte Parität einer Anzahl an Bosonen aufweist, die im harmonischen Oszillator (202) umfasst sind,
- eine Hilfsvorrichtung (201), die konfiguriert ist, um in einem Grundzustand |g> oder in einem angeregten Zustand |f> unter einer Vielzahl von angeregten Zuständen zu sein, wobei die Vorrichtung (201) dispersiv mit dem Oszillator (202) gekoppelt ist, sodass ein Frequenzunterschied zwischen dem Grundzustand 1 g> und dem angeregten Zustand 1 f> linear von einer Frequenzverschiebung $\chi$ und der Anzahl an Bosonen abhängig ist,

- einen Dissipator (203), der konfiguriert ist, um von einem angeregten Zustand | 1> in einen Grundzustand |0> überzugehen,

- einen Erreger (204), der konfiguriert ist, um einen ersten (205, 405) und zweiten (206, 406) Frequenzkamm zu erzeugen, die dazu bestimmt sind, zu mindestens einem unter dem harmonischen Quantenoszillator (202), der Hilfsvorrichtung (201) und dem Dissipator (203) geschickt zu werden, um ein Boson in dem harmonischen Oszillator (202) hinzuzufügen, wenn die Anzahl an Bosonen nicht die vorbestimmte Parität aufweist, **dadurch gekennzeichnet, dass** eine erste Frequenzabweichung, die zwei aufeinanderfolgende Kammscheitel des ersten Frequenzkamms (205, 405) trennt, gleich dem Doppelten der Frequenzverschiebung $\chi$ ist und gleich dem Doppelten einer zweiten Frequenzabweichung ist, die zwei aufeinanderfolgende Kammscheitel des zweiten Kamms (206, 406) trennt,

wobei der erste und zweite Kamm Spitzen in der Zeitdomäne aufweisen, wobei die Spitzen des ersten Kamms zeitlich in Bezug zu den Spitzen des zweiten Kamms versetzt sind.

2. System nach Anspruch 1, das weiter konfiguriert ist, um für jede ganze Zahl k einer Einheit von ganzen Zahlen zu sein:

- eine erste Stufe (401), die durch eine erste Anzahl an Bosonen gleich der ganzen Zahl k, den Grundzustand |g> und den Grundzustand |0> definiert ist,

- eine zweite Stufe (402) die durch eine zweite Anzahl an Bosonen gleich der ganzen Zahl k+1, den Grundzustand |g> und den Grundzustand |0> definiert ist,

- eine dritte Stufe (403), in der die Hilfsvorrichtung im angeregten Zustand |f> ist und der Dissipator im stabilen Zustand |0> ist,

- eine vierte Stufe (404), in der die Hilfsvorrichtung im Grundzustand |g> ist und der Dissipator im angeregten Zustand |1> ist, wobei der Erreger (204) konfiguriert ist, um für jede ganze Zahl k die erste, dritte und vierte Stufe zu koppeln, wenn die ganze Zahl k nicht die vorbestimmte Parität aufweist, um das System von der ersten Stufe (401) in die zweite Stufe (402) zu verschieben, wobei der Erreger (204) konfiguriert ist, um den ersten und zweiten Frequenzkamm zu generieren, sodass für jede ganze Zahl k:

- der erste Kamm (405) einen ersten Scheitel umfasst, wenn die ganze Zahl k nicht die vorbestimmte Parität aufweist, wobei der erste Scheitel eine Frequenz gleich einer Übergangsfrequenz zwischen der ersten und dritten Stufe aufweist, und

- der zweite Kamm (406) einen zweiten Scheitel umfasst, der eine Frequenz gleich einer Übergangsfrequenz zwischen der dritten und vierten Stufe aufweist.

3. System nach Anspruch 2 wobei der harmonische Oszillator (202) die zweite Anzahl an Bosonen gleich der ganzen Zahl k+1 in der vierten Stufe (402) umfasst.

4. System nach einem der Ansprüche 1 bis 3, wobei der harmonische Quantenoszillator (202) ein erster supraleitender Mikrowellenresonator ist, wobei das Hilfssystem (201) ein Transmon ist, der Dissipator (203) ein zweiter supraleitender Mikrowellenresonator ist, der einen Qualitätsfaktor aufweist, der kleiner ist als ein Qualitätsfaktor des ersten supraleitenden Mikrowellenresonators.

5. System nach einem der Ansprüche 1 bis 4, wobei eine Amplitude der Scheitel des ersten Frequenzkamms und des zweiten Frequenzkamms durch eine Kopplungsfrequenz gekennzeichnet ist, wobei die Kopplungsfrequenz kleiner als das Viertel der zweiten Frequenzabweichung ist.

6. System nach Anspruch 2 oder 3, wobei die Information in Zuständen des Oszillators codiert ist, die einer Anzahl an Bosonen entspricht, die zwischen einer Untergrenze einer ganzen Zahl $k_{min}$, welche die vorbestimmte Parität aufweist, und einer ersten Obergrenze $k_{max}$, welche die vorbestimmte Parität aufweist, umfasst ist, wobei die Einheit ganzer Zahlen gleich den ganzen Zahlen ist, die zwischen den ganzen Zahlen $k_{min}$ - 1 und $k_{max}$ - 1 umfasst sind.

7. Verfahren zur autonomen Stabilisierung von Quantenzuständen, die folgenden Schritte umfassend:

- Codieren einer Information in Zuständen eines harmonischen Quantenoszillators, wobei die Zustände eine vorbestimmte Parität einer Anzahl an Bosonen aufweisen, die im harmonischen Oszillator umfasst sind,

- dispersiv Koppeln des harmonischen Oszillators mit einer Hilfsvorrichtung, sodass ein Frequenzunterschied zwischen einem Grundzustand |g> der Hilfsvorrichtung und einem angeregten Zustand |f> der Hilfsvorrichtung linear von einer Frequenzverschiebung χ und der Anzahl an Bosonen abhängig ist,
- Koppeln der Hilfsvorrichtung mit einem Dissipator, der konfiguriert ist, um von einem angeregten Zustand |1> in einen Grundzustand |0> überzugehen,
- Generieren des ersten und zweiten Frequenzkamms, wobei eine erste Frequenzabweichung, die zwei aufeinanderfolgende Scheitel des ersten Frequenzkamms trennt, gleich dem Doppelten der Frequenzverschiebung χ ist und gleich dem Doppelten einer zweiten Frequenzabweichung ist, die zwei aufeinanderfolgende Kammscheitel des zweiten Kamms trennt, und
- Schicken des ersten und zweiten Frequenzkamms zu mindestens einem unter dem harmonischen Quantenoszillator, der Hilfsvorrichtung und dem Dissipator, um ein Boson in dem harmonischen Oszillator hinzuzufügen, wenn die Anzahl an Bosonen nicht die vorbestimmte Parität aufweist,

wobei der erste und zweite Kamm Spitzen in der Zeitdomäne aufweisen, wobei die Spitzen des ersten Kamms zeitlich in Bezug zu den Spitzen des zweiten Kamms versetzt sind.

8. Verfahren nach Anspruch 7, das weiter eine Optimierung der Amplitude der Scheitel des ersten und zweiten Frequenzkamms umfasst, wobei die Amplitude der Scheitel durch eine Kopplungsfrequenz gekennzeichnet ist, die folgenden Schritte umfassend:

- (E1) Auswählen eines Kopplungsfrequenzwerts kleiner als das Viertel der zweiten Frequenzabweichung,
- (E2) Messen einer Lebensdauer der Zustände, die eine Anzahl an Bosonen der vorbestimmten Parität aufweisen, und
- (E3) Ändern des Kopplungsfrequenzwertes in Abhängigkeit von der gemessenen Lebensdauer entsprechend einem Optimierungsalgorithmus der Lebensdauer, um einen optimalen Wert der Kopplungsfrequenz zu identifizieren, der einer maximalen Lebensdauer entspricht.

9. Verfahren nach Anspruch 7, das weiter eine Optimierung einer Entregungsrate $\gamma_{dis}$ gleich der Wahrscheinlichkeit umfasst, von der Stufe |1> zur Stufe |0> je Zeiteinheit überzugehen, die folgenden Schritt umfassend:

- (S1) Auswählen eines Entregungsratenwerts kleiner als die zweite Frequenzabweichung,
- (S2) Messen einer Lebensdauer der Zustände, die eine Anzahl an Bosonen der vorbestimmten Parität aufweisen, und
- (S3) Ändern des Entregungsratenwerts in Abhängigkeit von der gemessenen Lebensdauer entsprechend einem Optimierungsalgorithmus der Lebensdauer, um einen optimalen Wert der Entregungsrate zu identifizieren, der einer maximalen Lebensdauer entspricht.

**Claims**

1. A system (200) for autonomous stabilization of quantum states comprising:

- a quantum harmonic oscillator (202) configured to carry information encoded in states of the oscillator having a predetermined parity of a number of bosons comprised in the harmonic oscillator (202),
- an auxiliary device (201) configured to be in a ground state |g> or in an excited state |f> among a plurality of excited states, the device (201) being dispersively coupled to the oscillator (202), so that a frequency difference between the ground state |g> and the excited state |f> depends linearly on a frequency shift χ and on the number of bosons,
- a dissipator (203) configured to switch from an excited state |1> to a ground state |0>,
- an exciter (204) configured to generate first (205, 405) and second (206, 406) frequency combs, intended to be sent to at least one of the quantum harmonic oscillator (202), the auxiliary device (201) and the dissipator (203) so as to add a boson in the harmonic oscillator (202) if the number of bosons does not have the predetermined parity, **characterized in that** a first frequency difference separating two successive lines of the first frequency comb (205, 405) is equal to twice the frequency shift χ and is equal to twice a second frequency difference separating two successive lines of the second comb (206, 406), wherein the first and second combs have peaks in the time domain, the peaks of the first comb being time-shifted relative to the peaks of the second comb.

2. The system according to claim 1, further configured to be, for each integer k of a set of integers, in:

- a first level (401) defined by a first number of bosons equal to the integer k, the ground state |g> and the ground state |0>,
- a second level (402) defined by a second number of bosons equal to the integer k+1, the ground state |g> and the ground state |0>,
- a third level (403) in which the auxiliary device is in the excited state |f> and the dissipator is in the stable state |0>,
- a fourth level (404) in which the auxiliary device is in the ground state |g> and the dissipator is in the excited state |1>, the exciter (204) being configured to couple, for each integer k, the first, third and fourth levels if the integer k does not have the predetermined parity, so as to switch the system from the first level (401) to the second level (402), the exciter (204) being configured to generate the first and second frequency combs so that, for each integer k:

- the first comb (405) comprises a first line if the integer k does not have the predetermined parity, the first line having a frequency equal to a transition frequency between the first and third levels, and
- the second comb (406) comprises a second line having a frequency equal to a transition frequency between the third and fourth levels.

3. The system according to claim 2, wherein the harmonic oscillator (202) comprises the second number of bosons equal to the integer k+1 in the fourth level (402).

4. The system according to one of claims 1 to 3, wherein the quantum harmonic oscillator (202) is a first superconducting microwave resonator, the auxiliary system (201) is a transmon, the dissipator (203) is a second superconducting microwave resonator having a quality factor lower than a quality factor of the first superconducting microwave resonator.

5. The system according to one of claims 1 to 4, wherein an amplitude of the lines of the first frequency comb and of the second frequency comb is **characterized by** a coupling frequency, the coupling frequency being lower than the quarter of the second frequency difference.

6. The system according to claim 2 or 3, wherein the information is encoded in states of the oscillator corresponding to a number of bosons comprised between a floor integer $k_{min}$ having the predetermined parity and a ceiling integer $k_{max}$ having the predetermined parity, the set of integers being equal to the integers included between the integers $k_{min}$ - 1 and $k_{max}$ - 1.

7. A method for autonomous stabilization of quantum states comprising the following steps:

- encoding information in states of a quantum harmonic oscillator, the states having a predetermined parity of a number of bosons comprised in the harmonic oscillator,
- dispersively coupling the harmonic oscillator to an auxiliary device, so that a frequency difference between a ground state |g> of the auxiliary device and an excited state |f> of the auxiliary device depends linearly on a frequency shift $\chi$ and the number of bosons,
- coupling the auxiliary device to a dissipator configured to switch from an excited state |1> to a ground state |0>
- generating first and second frequency combs, a first frequency difference separating two successive lines of the first frequency comb being equal to twice the frequency shift $\chi$ and equal to twice a second frequency difference separating two successive lines of the second comb, and
- sending the first and second frequency combs to at least one amongst the quantum harmonic oscillator, the auxiliary device and the dissipator so as to add a boson in the harmonic oscillator if the number of bosons does not have the predetermined parity,

wherein the first and second combs have peaks in the time domain, the peaks of the first comb being time-shifted relative to the peaks of the second comb.

8. The method according to claim 7, further comprising an optimization of the amplitude of the lines of the first and second frequency combs, the amplitude of the lines being **characterized by** a coupling frequency, comprising the following steps:

- (E1) selecting a coupling frequency value lower than the quarter of the second frequency difference,
- (E2) measuring a lifetime of the states having a number of bosons of the predetermined parity, and
- (E3) modifying the value of the coupling frequency based on the lifetime measured according to an optimization algorithm of the lifetime so as to identify an optimal value of the coupling frequency corresponding to a maximum of the lifetime.

9. The method according to claim 7, further comprising an optimization of a de-energization rate $\gamma_{dis}$ equal to the probability of switching from the level |1> into the level |0> per unit of time, comprising the following steps:

- (S1) selecting a value of the de-energization rate lower than the second frequency difference,
- (S2) measuring a lifetime of the states having a number of bosons of the predetermined parity, and
- (S3) modifying the value of the de-energization rate based on the lifetime measured according to an optimization algorithm of the lifetime so as to identify an optimal value of the de-energization rate corresponding to a maximum of the lifetime.

# Figure 1

# Figure 2

## Figure 3

## Figure 4

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **OFEK NISSIM et al.** Extending the lifetime of a quantum bit with error correction in superconducting circuits. *Nature*, vol. 536, 441, 445
- **MICHAEL MARIOS H. et al.** New Class of Quantum Error-Correcting Codes for a Bosonic Mode. *Physical Review X*, vol. 6, 031006
- **GERTLER JEFFREY M. et al.** *Protecting a Bosonic Qubit with Autonomous Quantum Error Correction*, https://arxiv.org/abs/2004.09322
- **MIRRAHIMI NJP et al.** Dynamically protected cat-qubits: a new paradigm for universal quantum computation. *New Journal of Physics*, vol. 16

- **BLAIS ALEXANDRE et al.** Cavity quantum electrodynamics for superconducting electrical circuits: An architecture for quantum computation. *Physical Review A*, vol. 69, 062320
- **GERTLER JEFFREY M. ; PECHAL M. et al.** Microwave-Controlled Generation of Shaped Single Photons in Circuit Quantum Electrodynamics. *Physical Review X*, vol. 4, 041010
- **CAMPAGNE-IBARCQ P. et al.** Deterministic Remote Entanglement of Superconducting Circuits through Microwave Two-Photon Transitions. *Physical Review Letters*, vol. 120, 200501